# FASCICULE DE BREVET EUROPEEN

(11) **EP 3 190 621 B1**
(45) Date de publication et mention de la délivrance du brevet: **13.07.2022**
(21) Numéro de dépôt: 17150548.0
(22) Date de dépôt: 06.01.2017
(51) Int. Cl.: H01L 27/146, H01L 21/762

(54) **DISPOSITIF HYBRIDE DE DETECTION MULTISPECTRALE A BASE D'ELEMENTS MONOLITHIQUES**
HYBRID-VORRICHTUNG ZUR MULTISPEKTRALEN ERKENNUNG ANHAND VON MONOLITHISCHEN ELEMENTEN
HYBRID MULTI-SPECTRAL DETECTION DEVICE USING MONOLITHIC ELEMENTS

(30) Priorité: 08.01.2016 FR 1600041
(43) Date de publication de la demande: 12.07.2017
(73) Titulaire: THALES, 92400 Courbevoie (FR)
(72) Inventeur: DARTOIS, Thierry, 06156 CANNES LA BOCCA Cedex (FR); RENARD, Christophe, 06156 CANNES LA BOCCA Cedex (FR); REVERCHON, Jean-Luc, 91767 PALAISEAU Cedex (FR)
(74) Mandataire: Marks & Clerk France

(56) Documents cités:
- EP-A1- 0 605 898
- WO-A1-2013/109955
- WO-A1-2013/182763
- FR-A1- 2 966 977
- US-A1- 2003 193 589
- US-A1- 2015 054 962

## Description

La présente invention concerne le domaine des détecteurs électro-optiques notamment ceux destinés à être embarqués à bord des plateformes aéroportées. La présente invention concerne plus particulièrement un dispositif hybride constitué d'éléments monolithiques permettant la détection multispectrale couvrant le spectre visible et une partie du spectre infrarouge. Un dispositif hybride à base d'éléments monolithiques permettant la détection multispectrale est notamment divulgué dans la demande de brevet US 2015/054962 A1. Un dispositif de détection de rayonnement visible et proche infrarouge est connu du document FR 2 966 977 A1.

L'invention peut trouver son application, par exemple, dans le domaine de l'observation de la Terre depuis l'espace aérien ou l'observation astronomique de planète ou d'exoplanète depuis l'espace. Dans le cadre de mission d'observation de la Terre, il peut être intéressant d'étendre le fonctionnement du ou des instruments d'observation au-delà de la bande spectrale visible, par exemple à la bande infrarouge afin d'extraire plus d'information sur la zone observée. Un problème se pose avec les détecteurs à base de silicium utilisés classiquement pour l'observation dans le spectre visible car ce matériau n'a pas de réponse spectrale dans le domaine de l'infrarouge. La sensibilité spectrale du silicium se limite aux longueurs d'onde d'environ 0.95 µm.

Dans ce contexte, il est intéressant de proposer une solution permettant d'étendre la sensibilité spectrale des détecteurs.

Une solution consiste à ajouter un détecteur supplémentaire physiquement indépendant du détecteur fonctionnant dans le domaine visible afin de couvrir une partie de la bande infrarouge. Le plan focal d'un tel instrument spatial permet ainsi de couvrir l'ensemble des bandes du domaine visible, proche infrarouge, et infrarouge de courte longueur d'onde (ou SWIR pour ^{«} *Short Wave Infra Red*^{»} selon la terminologie anglo-saxonne). Cette solution requiert donc deux types de détecteurs différents et donc deux circuits de lecture ainsi que deux modules de commandes afin de piloter les détecteurs. Ceci a pour conséquence d'augmenter le volume, la masse et la puissance dissipée par le plan focal et par l'électronique vidéo de pilotage du détecteur se qui se traduit par une augmentation significative des coûts.

Il est également connu de l'art antérieur, l'utilisation de détecteur à base de matériau II-VI et III-V couvrant l'ensemble des bandes spectrales comme par exemple un détecteur à base de Tellure / Mercure / Cadmium (HgCdTe) aminci et traité antireflet afin de répondre dans la bande visible. On rappelle que les matériaux II-VI sont des semi conducteurs formés par l'association d'éléments de la colonne II et de la colonne VI de la classification périodique des éléments. Il en va de même pour les matériaux III-V. Cependant, cette solution très spécialisée présente de nombreux inconvénients comme par exemple une température de fonctionnement plus faible, une taille limitée des hybrides obtenus avec interconnexion par billes d'indium, l'utilisation de fonderies moins évoluées que les fonderies CMOS, pour la fabrication du circuit de détection infrarouge. De plus cela nécessite un nombre important d'opérations technologiques. Ce qui se traduit par un coût élevé.

La demande de brevet FR 2 966 976, enseigne l'utilisation de pixels de quatre couleurs avec cohérence spatiale. Le détecteur comprend plusieurs groupes de quatre pixels élémentaires dont un est sensible au rayonnement infrarouge et est associé à un filtre opaque au rayonnement visible et trois autres pixels sensibles au rayonnement visible chacun étant associé à un filtre correspondant à une des trois couleurs élémentaires. Cependant ce dispositif ne permet pas de répondre au besoin d'un détecteur pour l'observation de la Terre depuis l'espace aérien car la réponse spectrale de chaque couleur ne peut être définie précisément. Cette solution ne permet pas d'intégrer un filtre interférentiel avec des fronts raides et une largeur de bande stricte comme le requiert la majorité des instruments optiques d'observation. Elle est également incompatible avec la configuration de type râteau ou ^{«} pushbroom ^{»} détaillée plus loin.

Un but de l'invention est notamment de corriger les inconvénients de l'art antérieur en proposant un dispositif compact de détection multispectrale réduisant le nombre de plans focaux et dont la sensibilité spectrale s'étend au delà du spectre visible.

A cet effet, l'invention a pour objet un dispositif hybride de détection multispectral à base d'éléments monolithiques, tel que défini dans la revendication 1, comprenant :
- Un substrat de silicium
- un premier détecteur implanté dans un substrat silicium, ledit premier détecteur comprenant une pluralité de premiers capteurs juxtaposés, lesdits premiers capteurs étant configurés pour fournir un signal électrique dépendant du rayonnement électromagnétique reçu dans le domaine visible et proche infrarouge et chaque premier capteur étant disposé de façon à former un premier groupe d'au moins une ligne de premiers capteurs,
- un deuxième détecteur implanté dans un substrat absorbant comprenant au moins un matériau III-V ou II-VI, ledit deuxième détecteur comprenant une pluralité de deuxièmes capteurs juxtaposés, lesdits deuxièmes capteurs étant configurés pour fournir un signal électrique dépendant du rayonnement électromagnétique reçu dans le domaine infrarouge, chaque deuxième capteur étant disposé de façon à former un deuxième groupe d'au moins une ligne de deuxièmes capteurs, les lignes desdits premier et deuxième groupe d'au moins une ligne étant parallèles entre-elles,
- un premier filtre interférentiel et un deuxième filtre interférentiel recouvrant respectivement le premier et le deuxième détecteur, lesdits filtres étant chacun configuré pour filtrer le rayonnement électromagnétique reçu par les capteurs des détecteurs et chaque filtre ayant une fenêtre de transmission spectrale différente,
- un circuit de lecture commun aux deux détecteurs, ledit circuit de lecture étant implanté dans le substrat silicium, et étant configuré pour intégrer simultanément et de façon synchrone les signaux issus des différents capteurs et pour fournir, en sortie, au moins un signal vidéo représentatif du rayonnement électromagnétique reçu par l'ensemble des capteurs,
le deuxième détecteur étant collé sur le substrat silicium, chaque capteur du deuxième détecteur comprenant au moins une connexion configurée pour faire transiter les signaux du capteur au circuit de lecture.

Selon l'invention, le substrat absorbant recouvre uniquement une zone du substrat silicium dépourvue de premiers capteurs.

Avantageusement, les deuxièmes capteurs sont disposés de façon à former un deuxième groupe de plusieurs lignes de deuxièmes capteurs dans un plan perpendiculaire à une direction d'empilement du substrat silicium et du substrat absorbant.

Avantageusement, les deuxièmes capteurs sont distants du bord du substrat absorbant dans ledit plan.

Avantageusement, la distance séparant chaque deuxième capteur du bord du substrat absorbant dans ledit plan est supérieure à la longueur de diffusion des porteurs dans le substrat absorbant.

Avantageusement, les premiers capteurs et les deuxièmes capteurs sont séparés d'une distance comprise entre 10 micromètres et 20 micromètres selon une direction d'empilement du substrat silicium et du substrat absorbant.

Avantageusement, le substrat absorbant est réalisé en Indium Arséniure de Gallium.

Avantageusement, les deuxièmes capteurs sont configurés pour fournir un signal électrique proportionnel au rayonnement électromagnétique reçu dans le domaine infrarouge, et les premiers capteurs et les premiers capteurs sont configurés pour fournir un signal électrique proportionnel au rayonnement électromagnétique reçu dans le domaine visible et proche Infra Rouge.

Suivant un mode de réalisation, les capteurs du deuxième détecteur sont configurés pour couvrir le domaine spectral du proche infrarouge, et celui de l'infrarouge de courte et moyenne longueur d'onde.

Suivant un mode de réalisation, au moins un détecteur comprend une matrice de capteurs.

Suivant un mode de réalisation, le détecteur est à un détecteur à décalage temporel et intégration.

Suivant un mode de réalisation, le dispositif hybride de détection multispectrale comprend un dispositif de refroidissement configuré pour abaisser la température des deuxièmes capteurs.

L'invention a également pour objet un système de détection multispectrale destiné à être embarqué sur une plateforme aéroportée, ledit système comprenant un dispositif hybride de détection multispectrale selon une des revendications précédentes, au moins une lentille configurée pour focaliser le rayonnement électromagnétique dans un plan médian entre les plans dans lesquels sont implantés les différents capteurs dudit dispositif de détection, un module de commande et de traitement vidéo, un module de compression et de mémorisation du signal.

Suivant un mode de réalisation, le système comprend un dispositif de transmission.

Suivant un mode de réalisation, le système comprend un dispositif de balayage configuré pour déplacer le dispositif de détection.

Suivant un mode de réalisation, le système comprend au moins un dispositif de réflexion mobile configuré pour balayer les sous fauchées à observer.

Suivant un mode de réalisation, le système est configuré pour balayer une zone à observer selon un mode de prise de vue en ^{«} râteau ^{»}.

L'invention a également pour objet l'utilisation d'un dispositif hybride de détection multispectrale tel que présenté précédemment, dans laquelle le rayonnement électromagnétique est reçu sur la face, du substrat silicium, sur laquelle est collé le deuxième détecteur.

Suivant un mode de mise en œuvre, le dispositif hybride de détection multispectrale est utilisé avec un rayonnement électromagnétique reçu sur la face, du substrat silicium, opposée à celle sur laquelle est collé le deuxième détecteur.

Suivant un mode de mise en œuvre, le dispositif hybride de détection multispectrale est utilisé dans un système de détection multispectrale tel que présenté précédemment.

D'autres particularités et avantages de la présente invention apparaîtront plus clairement à la lecture de la description ci-après, donnée à titre illustratif et non limitatif, et faite en référence aux dessins annexés, sur lesquels :
- La figure 1 illustre le mode de prise de vue de type ^{«} râteau ^{»} ;
- La figure 2a représente un exemple de mode de réalisation d'un dispositif de détection selon l'invention ;
- La figure 2b représente un plan de coupe transversal d'un exemple de mode de réalisation d'un dispositif de détection selon l'invention ;
- La figure 3 illustre la connexion entre les capteurs sensible aux infrarouges et le circuit de lecture ;
- La figure 4 représente un exemple de mode de réalisation d'un système de détection selon l'invention ;
- La figure 5 représente un plan de coupe transversal d'un exemple de mode de réalisation d'un dispositif de détection selon l'invention.

Il convient de noter que l'utilisation du terme ^{«} *plateforme aéroporté*e ^{»} désigne tout type de plateforme aéroportée susceptible d'embarquer le dispositif de détection selon l'invention. Il peut s'agir par exemple, d'un satellite, un aéronef, un drone, un ballon ou tout type de plateforme aéroportée équivalente. Cependant, dans la description suivante, le terme ^{«} *plateforme aéroportée* ^{»} renvoie préférentiellement à un satellite d'observation de la Terre, qu'il soit géostationnaire ou non, et de façon plus générale à un satellite d'observation astronomique de planète ou d'exoplanète depuis l'espace.

De même le terme ^{«}Terre^{»} désigne aussi bien les zones terrestres que les zones maritimes.

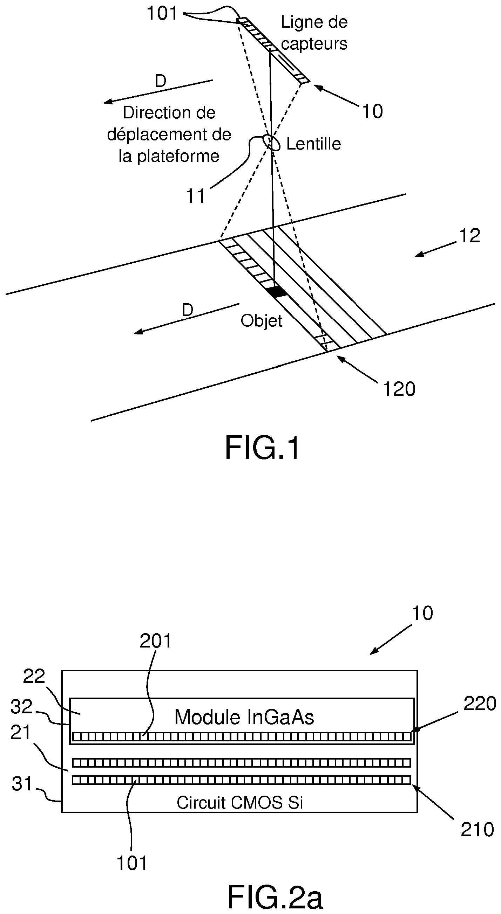

La figure 1 illustre le mode de prise de vue en râteau ou ^{«} *pushbroom* ^{»} selon la terminologie anglo-saxonne. Dans cet exemple, afin de ne pas surcharger la figure, le détecteur 10 a été réduit à une ligne unique de capteurs 101 ou éléments photosensibles élémentaires juxtaposés. On suppose que le détecteur 10 est embarqué sur une plateforme aéroportée et que cette plateforme se déplace suivant une direction D perpendiculaire à l'alignement des capteurs 101 du détecteur 10.

Au cours du défilement de la zone à observer par rapport au détecteur, au moins une lentille 11 focalise l'image d'une bande de Terre ou sous fauchée 120 dans un plan focal sur lequel est placée la ligne de capteurs 101 du détecteur 10. Une sous fauchée 120 correspond à la zone imagée par une ou plusieurs lignes d'éléments photosensibles élémentaires qui sont utilisés à un même instant pour l'observation par le détecteur 10. Chaque capteur 101 intègre le rayonnement reçu pendant le temps de pose et le transforme en un signal électrique dépendante de ce rayonnement, par exemple proportionnel à ce rayonnement. Un tel mode de balayage permet de saisir en image une bande totale de la zone à observer, comme par exemple la surface terrestre, appelée fauchée, dont la largeur est égale à celle d'une sous-fauchée et la longueur égale à celle de la sous fauchée multipliée par le nombre de sous-fauchées observées.

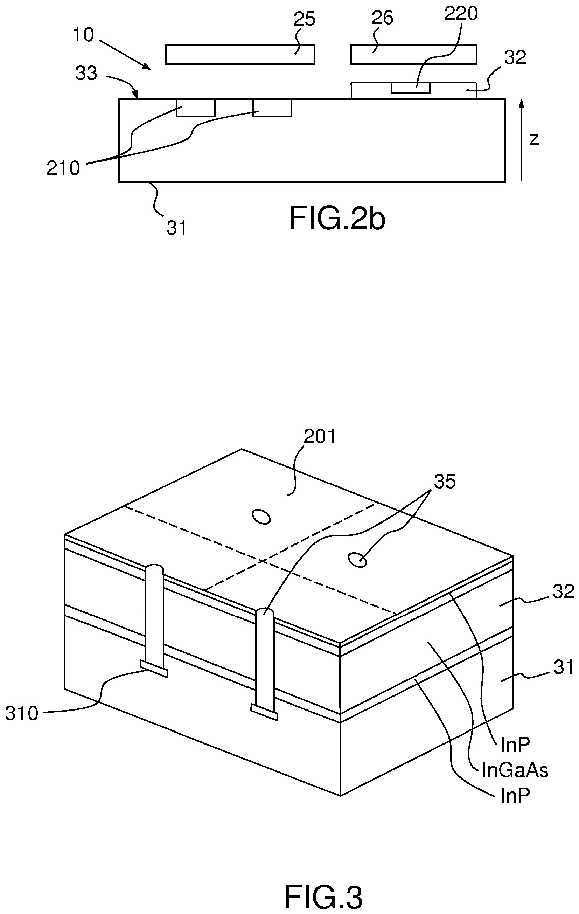

Les figures 2a et 2b représentent différentes vues d'un exemple de mode de réalisation d'un dispositif hybride de détection 10 multispectrale à base d'éléments monolithiques selon l'invention.

Le dispositif hybride de détection 10 comprend un premier détecteur 21 directement implanté dans un circuit CMOS, pour ^{«} *Complementary Métal Oxide Semiconductor*^{»} selon la terminologie anglo-saxonne, réalisé dans un support silicium 31 et un deuxième détecteur 22 implanté dans un matériau II-VI, dans un matériau III-V comme par exemple de l'Arséniure d'Indium et de Gallium ou InGaAs, dans un super-réseau de matériaux III-V ou II-VI ou dans un alliage digital de tels matériaux.

On rappelle que les matériaux III-V (ou II-VI) sont des semi conducteurs formés par l'association d'éléments de la colonne III et de la colonne V (ou de la colonne II et de la colonne VI) de la classification périodique des éléments. De même, un super-réseau correspond à un empilement périodique de couches de faibles épaisseurs, typiquement, des couches de matériaux de plusieurs nanomètres d'épaisseur. Un alliage digital est un super-réseau de période nettement inférieure à la longueur d'onde de de Broglie qui ne tolère pas de localisation des porteurs.

Le dispositif hybride de détection 10 comprend un substrat dit absorbant 32. Le substrat absorbant est continu. Le substrat absorbant 32 comprend au moins un matériau pris parmi un matériau II-VI et un matériau III-V. Le substrat absorbant est par exemple composé d'un matériau pris parmi un matériau III-V, un matériau II-VI, un super-réseau de matériaux III-V ou II-VI ou un alliage digital de tels matériaux. Le deuxième détecteur 22 est implanté dans le substrat absorbant 32. Le dispositif hybride de détection 10 comprend un empilement comprenant le substrat absorbant 32 et le substrat de silicium 31 empilés selon une direction d'empilement z visible sur la figure 2b.

Le dispositif hybride de détection 10 est obtenu par collage du substrat 32 en matériaux III-V ou II-VI épitaxié sur le support 31 silicium, par exemple par collage moléculaire.

L'empilement peut comprendre au moins une couche d'InP qui a pour fonction de limiter les effets de bord de nature électrique. Sur la réalisation de la figure 3, l'empilement comprend deux couches d'InP.

Le premier détecteur 21 comprend une pluralité de premiers capteurs 101 ou photodétecteurs élémentaires juxtaposés et disposés dans un même plan. Ce plan est perpendiculaire à l'axe z d'empilement. Les photodétecteurs peuvent par exemple être des photodiodes PIN.

Les premiers capteurs 101 sont disposés de façon à former au moins une ligne de détection 210. Une ligne de détection comprend plusieurs premiers capteurs 101. Lorsque le premier détecteur comprend plusieurs lignes 210 de capteurs 101, chacune des lignes sont parallèles deux à deux. Autrement dit, les lignes 210 sont toutes parallèles entre elles. Chaque premier capteur 101 est configuré pour fournir un signal électrique dépendant du rayonnement électromagnétique reçu par ledit capteur 101 dans le domaine visible et le proche Infra Rouge, c'est-à-dire jusqu'à une longueur d'onde d'environ 950 nm. Le signal électrique est par exemple, de façon non limitative, proportionnel au rayonnement électromagnétique.

Le deuxième détecteur 22 comprend une pluralité de deuxièmes capteurs 201 ou photodétecteurs élémentaires juxtaposés et disposés dans un même plan. Ce plan est perpendiculaire à l'axe z.

Les deuxièmes capteurs 201 sont implantés dans le substrat absorbant 32. L'implantation de plusieurs capteurs dans un même substrat permet de limiter les effets de bord, notamment les courants d'obscurité, sur les deuxièmes capteurs 201 et de faciliter la réalisation du deuxième détecteur (un seul substrat absorbant est déposé pour plusieurs capteurs).

Avantageusement, les deuxièmes capteurs 201 sont distants du bord du substrat 32 dans un plan perpendiculaire à la direction d'empilement z, c'est-à-dire dans le plan des deuxièmes capteurs 22. Cela permet de limiter les effets de bord.

Avantageusement, la distance séparant chaque capteur 201, notamment le bord de chaque capteur 201, du bord du substrat 32 dans un plan perpendiculaire à la direction z, c'est-à-dire dans le plan des deuxièmes capteurs 22, est supérieure à la longueur de diffusion des porteurs dans le substrat absorbant. Cette distance est typiquement supérieure à 100 µm.

Les premier détecteur 21 et deuxième détecteur 22 sont tous les deux disposés sur la même face du substrat silicium 31 dans des plans très proches que l'on peut considérer comme identiques du point de vue du système de détection dans lequel il est installé. Plus précisément, les premiers capteurs 101 sont disposés de part et d'autre de la face 33 du substrat 31 sur laquelle est collé le substrat absorbant 32. L'écart entre les deux plans peut être de l'ordre de la dizaine de micromètre. Cette distance est considérée selon l'axe z. Avantageusement, l'écart entre les deux détecteurs selon l'axe z est compris entre 10 micromètres et 20 micromètres. Cette proximité permet d'améliorer la mise au point.

Les deuxièmes capteurs 201 sont disposés de façon à former au moins une ligne de détection 220. Une ligne de détection 220 comprend plusieurs premiers capteurs 201.

Lorsque le deuxième détecteur comprend plusieurs lignes 220 de capteurs 201, chacune des lignes sont parallèles deux à deux. Autrement dit, les lignes 220 sont toutes parallèles entre elles. Ces lignes 220 sont implantées dans le même substrat 32. De même, chaque ligne 210, 220 du premier détecteur 21 et du deuxième détecteur 22 sont parallèles entre elles. Autrement dit, les lignes 210 et 220 sont toutes parallèles entre elles.

Les projections orthogonales des premiers capteurs 101 sur un plan perpendiculaire à l'axe z sont distantes des projections orthogonales des deuxièmes capteurs 201. Autrement dit, les premiers capteurs 101 et les deuxièmes capteurs 201 ne se recouvrent pas. Cela limite l'effet de masquage des capteurs des deux types de capteurs l'un sur l'autre dans deux modes d'illumination (« face avant » et « face arrière »).

Les projections orthogonales du premier détecteur 21 et du deuxième détecteur 22 sur un plan perpendiculaire à l'axe z sont distantes l'une de l'autre. Autrement dit, les deux détecteurs ne se recouvrent pas.

Le substrat absorbant 32 recouvre uniquement une zone du substrat silicium 31 dépourvue de premiers capteurs 101. Autrement dit, le substrat 32 n'est pas situé en regard des premiers capteurs 101. La projection orthogonale du substrat 32 sur un plan perpendiculaire à l'axe d'empilement z est distante de la projection orthogonale des premiers capteurs 101 sur ce plan. Cela limite encore l'effet de masquage du premier détecteur 21 par le deuxième détecteur 22 en éclairage face avant (qui sera décrit plus tard).

Chaque deuxième capteur 201 est configuré pour fournir un signal électrique dépendant du rayonnement électromagnétique reçu par ledit deuxième capteur 201 dans le domaine spectral de l'infrarouge. Par exemple, de façon non limitative, chaque deuxième capteur 201 est configuré pour fournir un signal électrique proportionnel au rayonnement électromagnétique reçu par ledit deuxième capteur 201 dans le domaine spectral de l'infrarouge.

Dans le cas de l'utilisation de l'Arséniure d'Indium et de Gallium (InGaAs) pour le matériau absorbant 32 du deuxième détecteur 22, les capteurs 201 dudit deuxième détecteur 22 pourront couvrir le proche infrarouge, ainsi que l'infrarouge de courte et moyenne longueur d'onde (ou SWIR pour ^{«} *Short Wave Infra Red*^{»} selon la terminologie anglo-saxonne) jusqu'à une longueur d'onde d'environ 1,65 µm sans refroidissement du détecteur.

Suivant un mode de réalisation, le deuxième détecteur 22 peut nécessiter d'être refroidi. Pour cela, le détecteur hybride 10 peut comprendre un dispositif de refroidissement configuré pour faire baisser la température de la totalité dudit détecteur 10. La température des deuxièmes capteurs peut ainsi être abaissée ce qui permet d'augmenter leur sensibilité. A titre d'exemple, baisser la température du détecteur 22 à 100K (soit 173°C) permet aux deuxièmes capteurs de fonctionner à une longueur d'onde de l'ordre de 5 µm.

Suivant un autre mode de réalisation, afin d'augmenter la sensibilité des deuxièmes capteurs 201 sensibles aux infrarouge, le substrat 32 absorbant les photons en matériau(x) III-V et/ou II-VI nécessite d'être aminci afin de favoriser le facteur de forme. De façon avantageuse, le fait de réduire l'épaisseur du substrat en matériau III-V permet d'augmenter la sensibilité des deuxièmes capteurs 201 au-dessous de 950 nm (proche infra Rouge). Le terme ^{«} substrat aminci ^{»} peut correspondre à un substrat de quelques dizaines de micromètres d'épaisseur en rapport avec un substrat non aminci qui peut correspondre à un substrat d'une épaisseur de quelques centaines de micromètres.

Il est possible d'étendre la longueur de détection au-delà de 1,65 µm jusqu'à une longueur d'onde de l'ordre de 2,2 µm sans avoir à diminuer la température du détecteur 22 en employant un super-réseau InGaAs / GaAsSb, un alliage digital InₓGa₁₋ₓAs / In_{y}Ga_{1y}As à contrainte compensée ou un alliage InGaAs contraint. Cela permet d'éviter d'utiliser un dispositif de refroidissement et donc de pénaliser la compacité du dispositif de détection 10.

Suivant un mode de réalisation, au moins un détecteur 21, 22 peut comprendre au moins une matrice de détection formée de plusieurs lignes de capteurs 101 ou respectivement 201 jointives.

Suivant un mode de réalisation, la matrice de capteurs, c'est-à-dire le détecteur correspondant 21 ou 22 est du type à décalage temporel et intégration ou TDI pour ^{«} *Time-Delay and Integration*^{»}*.* Le détecteur à décalage temporel et intégration comprend un circuit de temporisation configuré pour commander un décalage temporel d'intégration des différentes lignes de la matrice. Lors du défilement de la zone à observer, une fois la première ligne exposée, la charge est transférée à la ligne voisine. Lorsque la zone imagée ou sous fauchée 120 effectue la distance de séparation entre la première ligne et la deuxième ligne, une seconde exposition est effectuée au-dessus de la première, et ainsi de suite. Ainsi, chaque sous fauchée 120 est imagée à plusieurs reprises, et les expositions sont ajoutées les unes aux autres. De façon avantageuse, cela permet d'augmenter le rapport signal à bruit, et ainsi d'améliorer la qualité de l'image résultant d'une prise de vue utilisant l'objet de l'invention. Ce type de dispositif de détection est intéressant en cas de rayonnement de faible intensité en effet les expositions successives permettent d'augmenter le temps de pose total.

Un premier filtre interférentiel 25 et un deuxième filtre interférentiel 26 recouvrent respectivement le premier et le deuxième détecteur. Autrement dit, le premier filtre interférentiel 25 recouvre uniquement le premier détecteur 21 et le deuxième filtre interférentiel 26 recouvre uniquement le deuxième détecteur 22. Chaque filtre interférentiel 25 est configuré pour filtrer le rayonnement électromagnétique reçu par les capteurs 101 des détecteurs 21, 22 avec des fenêtres de transmission spectrale différentes. Les fenêtres de transmission présentant un gabarit contraint, c'est-à-dire un gabarit prédéterminé, c'est-à-dire une largeur prédéterminée. De façon avantageuse les fronts des fenêtres sont suffisamment raides pour obtenir un filtre sélectif avec une raideur ou sélectivité spectrale de l'ordre de 10 nm à 100 nm. Le coefficient de transmission du filtre passe donc de 1% à 99% sur une largeur spectrale de 10 nm à 100 nm.

Les fenêtres de transmission spectrales peuvent ne pas se recouvrir. En variante, les fenêtres de transmission spectrales peuvent se recouvrir partiellement.

En référence à la figure 3, le dispositif de détection comprend également un circuit de lecture 310 unique commun aux deux détecteurs 21, 22 implanté dans le substrat Silicium 31. Ce circuit de lecture 310 est configuré pour intégrer simultanément et de façon synchrone les signaux issus des différents capteurs 101, 201 des premier et deuxième détecteurs 21, 22 et pour fournir, en sortie, un signal vidéo représentatif du rayonnement électromagnétique reçu par l'ensemble des premier et deuxième capteurs. A cet effet, chaque capteur 101, 201 comprend au moins une connexion 35 reliant ledit capteur au circuit de lecture configurée pour faire transiter les signaux du capteur au circuit de lecture. Le circuit de lecture 310 peut être composé de transistors formés dans la couche de silicium 31 et reliés entre eux par des interconnexions. Suivant un exemple de mode de réalisation, le circuit de lecture 310 peut comprendre quatre ou cinq transistors par capteur.

La figure 3 illustre la connexion 35 entre les deuxièmes capteurs 201 intégrée dans le matériau absorbant 32 du deuxième détecteur 22 en matériau III-V et le circuit de lecture 310 intégré dans le substrat silicium 31. La connexion 35 ou ^{«}*loop-hole^{»}* selon la terminologie anglo-saxonne, permet de transmettre le courant entre le capteur 101 et le circuit de lecture 310 via une métallisation présente dans ladite connexion 35. La connexion 35 débouche sur la face du substrat absorbant 32 opposée au substrat de silicium 31. La zone de connexion assure également une fonction de diode. La connexion 35 permet de collecter des porteurs minoritaires, c'est à dire les trous pour un semi-conducteur de type n, dans le matériau III-V autour du via 35, et ensuite de recombiner ces porteurs minoritaires dans le via 35. Le courant est ensuite transmis vers le circuit de lecture CMOS. Ce type de connexion permet de faciliter la réalisation du dispositif hybride car cela permet de s'affranchir des contraintes d'alignement. La connexion 35 peut être réalisée après collage du matériau 32 sur le silicium 31 ce qui permet d'accéder à des dimensions de pixel plus petites. Ce type de connexion peut être réalisée quelque soit le(s) matériau (x) II-V et/ou II-VI formant le substrat 32.

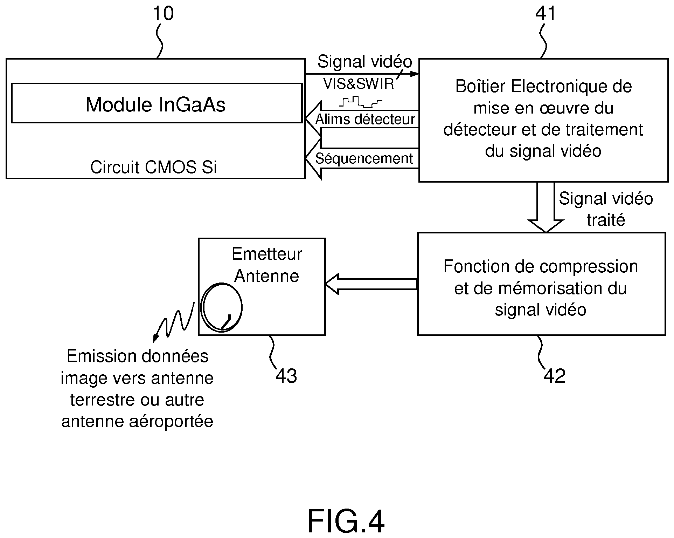

La figure 4 représente de façon schématique un exemple de mode de réalisation d'un système de détection multispectral selon l'invention.

Le système de détection comprend une optique comportant au moins une lentille 11 configurée pour focaliser le rayonnement électromagnétique de la sous fauchée 120 observée dans un plan focal, un dispositif hybride de détection 10 multispectral tel que décrit précédemment, un module de commande et de traitement vidéo 41 et un module de compression et de mémorisation du signal 42.

Le dispositif hybride de détection 10 est disposé dans le système de telle sorte que le plan focal de l'optique se situe dans un plan médian entre les plans dans lesquels sont implantés les différents capteurs 101, 201 des premier et deuxième détecteurs 21, 22.

Le module de commande et de traitement vidéo 41 est configuré pour mettre en œuvre les détecteurs 21, 22 du dispositif hybride de détection 10 et effectuer le traitement vidéo à partir des signaux vidéo dans les domaines visible et infrarouge issus des premier et deuxième détecteurs 21, 22.

A cet effet, le dispositif de détection 10 peut également comprendre plusieurs entrées d'alimentation, pour alimenter par exemple le composant, la partie logique, la partie analogique, les diodes etc, et au moins une entrée configurée pour recevoir un signal de séquencement ; les alimentations continues, provenant par exemple d'au moins un convertisseur externe, et les signaux d'horloge étant fournis par le module de commande et de traitement vidéo 41, afin de piloter les différents détecteurs 21, 22.

Suivant un premier mode de réalisation le dispositif de détection 10 peut comprendre deux sorties vidéo, une étant dédiée aux signaux issus du premier détecteur 21 dans le domaine visible et une deuxième étant dédiée aux signaux issus du deuxième détecteur 22 dans le domaine infrarouge (proche infrarouge et infrarouge de courte longueur d'onde). Ces sorties vidéo sont connectées aux entrées vidéo du module de commande et de traitement vidéo 41 en vu du traitement vidéo.

Suivant un mode de réalisation alternatif, le dispositif de détection 10 peut comprendre une sortie vidéo unique, les signaux issus du premier détecteur 21 et ceux issus du deuxième détecteur 22 transitant par la même sortie et étant multiplexés. Dans ce cas, le module de commande et de traitement vidéo 41 possède également une entrée vidéo unique et une sortie de séquencement supplémentaire connectée à une entrée du dispositif de détection 10 et configurée pour fournir audit dispositif de détection 10 le signal d'horloge pour le multiplexage. De façon avantageuse, le multiplexage des signaux vidéo permet d'augmenter la compacité du système en remplaçant les deux chaînes vidéo par une chaîne vidéo unique traitant alternativement les signaux issus des premiers capteurs 101 sensibles au rayonnement dans le visible et ceux issus des deuxième capteurs 201 sensibles au rayonnement infrarouge.

Le module de commande et de traitement vidéo 41 comprend également une sortie vidéo connectée à une entrée du module de compression et de mémorisation du signal 42 afin de fournir, à ce dernier, le signal vidéo traité. Ce module 42 est configuré pour compresser le signal vidéo traité et le mémoriser. Le signal compressé peut par exemple être transmis à un dispositif de transmission 43 comprenant au moins un module d'émission et au moins un dispositif de transmission afin de transmettre le signal vidéo compressé vers un récepteur.

Suivant un autre mode de réalisation, le signal vidéo compressé peut par exemple être enregistré dans une zone mémoire du système de détection et/ou être transmis à un dispositif d'affichage.

Le système de détection multispectral est destiné à être embarqué sur une plateforme aéroportée en vue d'une mission d'observation. L'observation peut être effectuée suivant un mode de prise de vue de type râteau ou ^{«}*pushbroom*^{»} selon la terminologie anglo-saxonne.

Lorsque le système de détection est embarqué à bord d'un satellite géostationnaire, le système de détection peut comprendre un dispositif de balayage configuré pour déplacer le dispositif de détection 10 afin de compenser le fait que la sous fauchée 120 observée par les capteurs 101 et 201 est fixe. Le système peut ainsi observer différentes sous fauchées bien que la zone observée ne défile pas devant le système de détection.

Suivant un autre mode de réalisation, le dispositif de balayage peut comprendre au moins un dispositif de réflexion mobile, comme par exemple un miroir mobile, configuré pour renvoyer sur les capteurs des détecteurs le rayonnement électromagnétique de différentes sous fauchées. Le dispositif de balayage peut ainsi balayer les sous fauchée à observer.

Suivant un autre mode de réalisation, le système de détection multispectral peut être destiné à être embarqué à bord d'un satellite d'observation astronomique configuré pour observer au moins une planète ou au moins une exoplanète depuis l'espace.

Les différents modules comme le module de commande et de traitement vidéo 41, le module de compression, de mémorisation du signal 42 et le module de transmission peuvent être un ou plusieurs microprocesseurs, processeurs, ordinateurs ou tous autres moyens équivalents programmés de façon opportune.

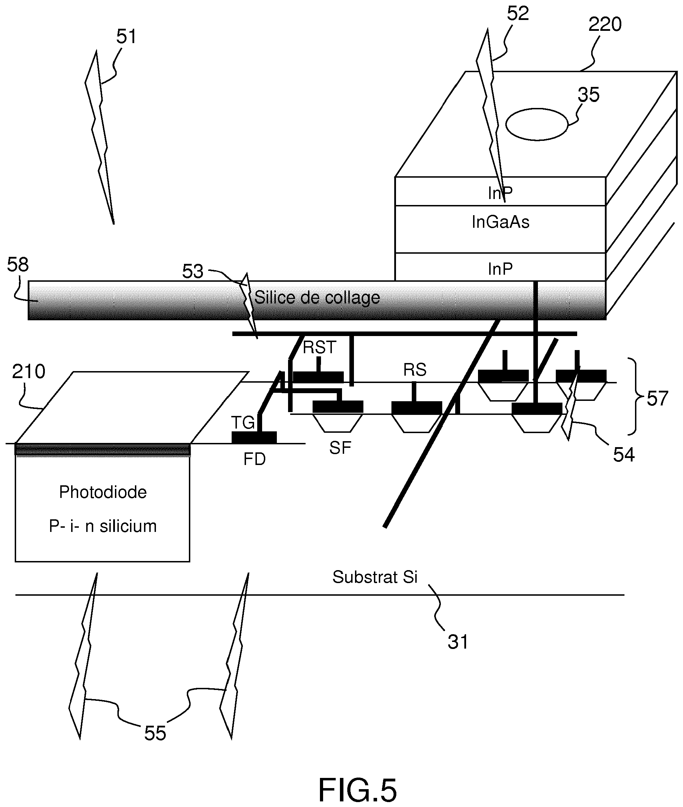

La figure 5 représente un plan de coupe transversal d'un exemple de mode de réalisation d'un dispositif hybride de détection 10 multispectral.

Le premier détecteur 21 comprend une ligne 210 de capteurs 101 implanté dans un substrat silicium 31. Le deuxième détecteur 22 comprend une ligne 220 de capteurs 101 implanté dans de l'InGaAs. Ce deuxième détecteur est collé sur le substrat en silicium 31 par l'intermédiaire d'une couche de collage 58. C'est plus précisément le substrat absorbant 32 dans lequel est implanté le deuxième détecteur qui est collé sur le substrat de silicium. Afin de ne pas surcharger la figure seul un capteur du premier détecteur et un capteur du deuxième détecteur sont représentés.

Cette figure illustre différentes façons d'utiliser le dispositif hybride de détection 10 multispectral. Selon un premier mode de mise en œuvre du dispositif 10, le rayonnement électromagnétique peut être reçu sur la face du substrat silicium 31, sur laquelle est collé le deuxième détecteur 22. Par la suite on appellera cette face, la ^{«}face avant ^{»} et ce mode d'illumination, ^{«}l'illumination face avant ^{»}. Ce mode d'éclairage permet d'optimiser les performances de la détection de la partie infrarouge du rayonnement électromagnétique, par contre la détection dans le visible est un peu dégradée. Si on se réfère à la figure 5, les photons de la bande infrarouge, comme par exemple le photon référencé 52, sont directement collectés par les capteurs 101 de la ligne 220 du deuxième détecteur 22. De même, une partie des photons de la bande visible, par exemple le photon référencé 51, est directement collectée par les capteurs 101 de la ligne 210 du premier détecteur 210. Une légère atténuation peut être due à la présence de la couche de collage 58 permettant de coller le deuxième détecteur 22 sur le substrat silicium 31. Une partie du rayonnement visible n'est pas collectée car seule une partie restreinte du capteur 101 est sensible au rayonnement visible est dédiée à la détection. Une grande partie de sa surface est dédiée à des transistors et des interconnexions 57. De ce fait, une partie du rayonnement visible, comme le photon référencé 53, est absorbée par les interconnexions 57.

Selon un autre mode de mise en œuvre du dispositif 10, le rayonnement électromagnétique peut être reçu sur la face arrière, c'est-à-dire sur la face, du substrat silicium 31, opposée à celle sur laquelle est collé le deuxième détecteur 22. Ce mode d'illumination est optimal pour la détection dans la partie visible du rayonnement électromagnétique reçu, par contre la détection dans le domaine de l'infrarouge est dégradée. En effet, toute la surface du substrat silicium 31 est photo sensible et permet donc aux photons visibles comme les photons référencés 55 éclairant la face arrière du substrat silicium 31 d'être collectés par le premier détecteur 21. Du fait de la présence des métallisations liées à l'électronique de lecture, aux interconnexions, une partie des photons du domaine infrarouge, comme le photon référencé 54, est stoppée et n'est pas collectée par le deuxième capteur 22. De même une partie de ces photons est absorbée par le substrat silicium 31 et ce même après amincissement de ce dernier.

Bien entendu, ces deux modes d'éclairage du dispositif 10 peuvent être mis en œuvre lorsque ledit dispositif hybride de détection multispectrale est implanté dans un système de détection multispectrale tel que décrit précédemment .

## Revendications

1. Dispositif hybride de détection (10) multispectrale à base d'éléments monolithiques, comprenant :
- un substrat de silicium (31),
- un premier détecteur (21) implanté dans le substrat silicium (31), ledit premier détecteur (21) comprenant une pluralité de premiers capteurs (101) juxtaposés, lesdits premiers capteurs (101) étant configurés pour fournir un signal électrique dépendant du rayonnement électromagnétique reçu dans le domaine visible et proche Infra Rouge et les premiers capteurs (101) étant disposés de façon à former un premier groupe d'au moins une ligne (210) de premiers capteurs,
- un deuxième détecteur (22) implanté dans un substrat absorbant (32) comprenant au moins un matériau pris parmi un matériau III-V et un matériau II-VI, ledit deuxième détecteur (22) comprenant une pluralité de deuxièmes capteurs (201) juxtaposés, lesdits deuxièmes capteurs (201) étant configurés pour fournir un signal électrique dépendant du rayonnement électromagnétique reçu dans le domaine infrarouge, les deuxièmes capteurs étant disposés de façon à former un deuxième groupe d'au moins une ligne (220) de deuxièmes capteurs, les lignes (210, 220) desdits premier et deuxième groupe d'au moins une lignes étant parallèles entre-elles, le deuxième détecteur (22) étant collé sur le substrat silicium (31), chaque capteur (201) du deuxième détecteur (22) comprenant au moins une connexion (35) configurée pour faire transiter les signaux du capteur (201) à un circuit de lecture (310) commun aux deux détecteurs (21, 22), ledit circuit de lecture étant implanté dans le substrat silicium (31), et étant configuré pour intégrer simultanément et de façon synchrone les signaux issus des différents capteurs (101, 201) et pour fournir, en sortie, au moins un signal vidéo représentatif du rayonnement électromagnétique reçu par l'ensemble des capteurs,
le dispositif hybride de détection (10) étant **caractérisé en ce que** :
- le substrat absorbant (32) recouvre uniquement une zone du substrat silicium (31) dépourvue de premiers capteurs (101),
- et **en ce que le dispositif hybride comprend** un premier filtre interférentiel (25) recouvrant le premier détecteur (21) et un deuxième filtre interférentiel (26) recouvrant le deuxième détecteur (22), lesdits filtres (25, 26) étant chacun configuré pour filtrer le rayonnement électromagnétique reçu par les capteurs (101, 201) des détecteurs (21, 22) et chaque filtre (25, 26) ayant une fenêtre de transmission spectrale différente.

2. Dispositif selon l'une quelconque des revendications précédentes, dans lequel les deuxièmes capteurs sont disposés de façon à former un deuxième groupe de plusieurs lignes de deuxièmes capteurs dans un plan perpendiculaire à une direction d'empilement du substrat silicium (31) et du substrat absorbant (32).

3. Dispositif selon la revendication précédente, dans lequel les deuxièmes capteurs sont distants du bord du substrat absorbant (32) dans ledit plan.

4. Dispositif selon la revendication précédente, dans lequel la distance entre chaque deuxième capteur (201) et le bord du substrat absorbant (32) dans ledit plan est supérieure à la longueur de diffusion des porteurs dans le substrat absorbant (32).

5. Dispositif selon l'une quelconque des revendications précédentes, dans lequel les premiers capteurs et les deuxièmes capteurs sont séparés d'une distance comprise entre 10 micromètres et 20 micromètres selon une direction d'empilement (z) du substrat silicium (31) et du substrat absorbant (32).

6. Dispositif (10) selon l'une quelconque des revendications précédentes, dans lequel le substrat absorbant est réalisé en Indium Arséniure de Gallium.

7. Dispositif selon l'une quelconque des revendications précédentes, dans lequel les deuxièmes capteurs (201) sont configurés pour fournir un signal électrique proportionnel au rayonnement électromagnétique reçu dans le domaine infrarouge, et les premiers capteurs (101) sont configurés pour fournir un signal électrique proportionnel au rayonnement électromagnétique reçu dans le domaine visible et proche Infra Rouge.

8. Dispositif (10) selon une des revendications précédentes dans lequel les capteurs (201) du deuxième détecteur (22) sont configurés pour couvrir le domaine spectral du proche infrarouge, et celui de l'infrarouge de courte et moyenne longueur d'onde.

9. Dispositif (10) selon une des revendications précédentes dans lequel au moins un des détecteurs comprend une matrice de capteurs (101, 201).

10. Dispositif (10) selon la revendication précédente, dans lequel au moins un des détecteurs est un détecteur à décalage temporel et intégration.

11. Dispositif (10) selon une des revendications précédentes dans lequel ledit dispositif hybride de détection (10) multispectrale comprend un dispositif de refroidissement configuré pour abaisser la température des deuxièmes capteurs (201).

12. Système de détection multispectrale destiné à être embarqué sur une plateforme aéroportée, ledit système étant **caractérisé en ce qu'**il comprend un dispositif hybride de détection (10) multispectrale selon une des revendications précédentes, au moins une lentille (11) configurée pour focaliser le rayonnement électromagnétique dans un plan médian entre les plans dans lesquels sont implantés les différents capteurs (101, 201) dudit dispositif de détection (10), un module de commande et de traitement vidéo (41), un module de compression et de mémorisation du signal (42).

13. Système selon la revendication précédente dans lequel le système comprend un dispositif de transmission (43).

14. Système selon une des revendications 12 à 13, dans lequel le système comprend un dispositif de balayage configuré pour déplacer le dispositif de détection (10).

15. Système selon une des revendications 12 à 13, dans lequel le système comprend au moins un dispositif de réflexion mobile configuré pour balayer les sous fauchées à observer.

16. Système selon une des revendications 12 à 13, dans lequel le système est configuré pour balayer une zone à observer selon un mode de prise de vue en ^{«} râteau ^{»}.

17. Utilisation d'un dispositif hybride de détection (10) multispectrale selon une des revendications 1 à 11 dans laquelle le rayonnement électromagnétique est reçu sur la face du substrat silicium (31), sur laquelle est collé le deuxième détecteur (22).

18. Utilisation d'un dispositif hybride de détection (10) multispectrale selon une des revendications 1 à 11 dans laquelle le rayonnement électromagnétique est reçu sur la face, du substrat silicium (31), opposée à celle sur laquelle est collé le deuxième détecteur (22).

19. Utilisation selon une des revendications 17 à 18, dans laquelle le dispositif hybride de détection multispectrale est implanté dans un système de détection multispectrale selon une des revendications 12 à 16.

## Patentansprüche

1. Hybride multispektrale Detektionsvorrichtung (10) auf der Basis von monolithischen Elementen, die Folgendes umfasst:
- ein Siliciumsubstrat (31),
- einen ersten Detektor (21), der in das Siliciumsubstrat (31) installiert ist, wobei der erste Detektor (21) eine Vielzahl nebeneinander angeordneter erster Sensoren (101) umfasst, wobei die ersten Sensoren (101) zum Bereitstellen eines elektrischen Signals konfiguriert sind, das von der im sichtbaren und nahen Infrarotbereich empfangenen elektromagnetischen Strahlung abhängt, und wobei die ersten Sensoren (101) so angeordnet sind, dass sie eine erste Gruppe von mindestens einer Reihe (210) von ersten Sensoren bilden,
- einen zweiten Detektor (22), der in einem absorbierenden Substrat (32) installiert ist, das mindestens ein Material aus einem III-V-Material und einem II-VI-Material umfasst, wobei der zweite Detektor (22) eine Vielzahl nebeneinander angeordneter zweiter Sensoren (201) umfasst, wobei die zweiten Sensoren (201) zum Bereitstellen eines elektrischen Signals angeordnet sind, das von der im Infrarotbereich empfangenen elektromagnetischen Strahlung abhängt, wobei die zweiten Sensoren so angeordnet sind, dass sie eine zweite Gruppe von mindestens einer Reihe (220) von zweiten Sensoren bilden, wobei die Reihen (210, 220) der ersten und zweiten Gruppe von mindestens einer Reihe parallel zueinander verlaufen, wobei der zweite Detektor (22) auf das Siliciumsubstrat (31) geklebt ist, wobei jeder Sensor (201) des zweiten Detektors (22) mindestens eine Verbindung (35) umfasst, die zum Leiten der Signale des Sensors (201) zu einer beiden Sensoren (21, 22) gemeinsamen Ausleseschaltung (310) konfiguriert ist, wobei die Ausleseschaltung in das Siliciumsubstrat (31) installiert und so konfiguriert ist, dass sie die Signale von den verschiedenen Sensoren (101, 201) gleichzeitig und synchron integriert und mindestens ein Videosignal ausgibt, das die von allen Sensoren empfangene elektromagnetische Strahlung repräsentiert,
wobei die hybride Detektionsvorrichtung (10) **dadurch gekennzeichnet ist, dass**:
- das absorbierende Substrat (32) nur eine Zone des Siliciumsubstrats (31) bedeckt, in der sich keine ersten Sensoren (101) befinden,
- und dadurch, dass die Hybridvorrichtung ein den ersten Detektor (21) bedeckendes erstes Interferenzfilter (25) und ein den zweiten Detektor (22) bedeckendes zweites Interferenzfilter (26) umfasst, wobei die Filter (25, 26) jeweils zum Filtern der von den Sensoren (101, 201) der Detektoren (21, 22) empfangenen elektromagnetischen Strahlung konfiguriert sind und jedes Filter (25, 26) ein unterschiedliches spektrales Transmissionsfenster hat.

2. Vorrichtung nach einem der vorherigen Ansprüche, wobei die zweiten Sensoren so angeordnet sind, dass sie eine zweite Gruppe von mehreren Reihen von zweiten Sensoren in einer Ebene lotrecht zu einer Stapelrichtung des Siliciumsubstrats (31) und des absorbierenden Substrats (32) bilden.

3. Vorrichtung nach dem vorherigen Anspruch, wobei die zweiten Sensoren in der Ebene entfernt vom Rand des absorbierenden Substrats (32) liegen.

4. Vorrichtung nach dem vorherigen Anspruch, wobei der Abstand zwischen jedem zweiten Sensor (201) und dem Rand des absorbierenden Substrats (32) in der Ebene größer ist als die Diffusionslänge der Ladungsträger in dem absorbierenden Substrat (32).

5. Vorrichtung nach einem der vorherigen Ansprüche, wobei die ersten Sensoren und die zweiten Sensoren um einen Abstand von 10 Mikrometern bis 20 Mikrometern in einer Stapelrichtung (z) des Siliciumsubstrats (31) und des absorbierenden Substrats (32) voneinander getrennt sind.

6. Vorrichtung (10) nach einem der vorherigen Ansprüche, wobei das absorbierende Substrat aus Indiumgalliumarsenid gefertigt ist.

7. Vorrichtung nach einem der vorherigen Ansprüche, wobei die zweiten Sensoren (201) zum Bereitstellen eines elektrisches Signals konfiguriert sind, das proportional zu der im Infrarotbereich empfangenen elektromagnetischen Strahlung ist, und die ersten Sensoren (101) zum Bereitstellen eines elektrischen Signals konfiguriert sind, das proportional zu der im sichtbaren und nahen Infrarotbereich empfangenen elektromagnetischen Strahlung ist.

8. Vorrichtung (10) nach einem der vorherigen Ansprüche, wobei die Sensoren (201) des zweiten Detektors (22) zum Abdecken des Spektralbereichs des nahen Infrarots und den des kurz- und mittelwelligen Infrarots konfiguriert sind.

9. Vorrichtung (10) nach einem der vorherigen Ansprüche, wobei mindestens einer der Detektoren eine Matrix von Sensoren (101, 201) umfasst.

10. Vorrichtung (10) nach dem vorherigen Anspruch, wobei mindestens einer der Detektoren ein Zeitverschiebungs- und Integrationsdetektor ist.

11. Vorrichtung (10) nach einem der vorherigen Ansprüche, wobei die hybride multispektrale Detektionsvorrichtung (10) eine Kühlvorrichtung umfasst, die zum Senken der Temperatur der zweiten Sensoren (201) konfiguriert ist.

12. Multispektrales Detektionssystem zum Einbauen in eine Flugzeugplattform, wobei das System **dadurch gekennzeichnet ist, dass** es Folgendes umfasst: eine hybride multispektrale Detektionsvorrichtung (10) nach einem der vorherigen Ansprüche, mindestens eine Linse (11), die zum Fokussieren der elektromagnetischen Strahlung in einer mittleren Ebene zwischen den Ebenen konfiguriert ist, in denen die verschiedenen Sensoren (101, 201) der Detektionsvorrichtung (10) installiert sind, ein Steuerungs- und Videoverarbeitungsmodul (41) und ein Modul zur Komprimierung und Speicherung des Signals (42).

13. System nach dem vorherigen Anspruch, wobei das System eine Sendevorrichtung (43) umfasst.

14. System nach einem der Ansprüche 12 bis 13, wobei das System eine Abtastvorrichtung umfasst, die zum Bewegen der Detektionsvorrichtung (10) konfiguriert ist.

15. System nach einem der Ansprüche 12 bis 13, wobei das System mindestens eine bewegliche Reflexionsvorrichtung umfasst, die zum Abtasten der zu beobachtenden Unterschwaden konfiguriert ist.

16. System nach einem der Ansprüche 12 bis 13, wobei das System zum Abtasten einer zu beobachtenden Zone in einem "Rake"-Aufnahmemodus konfiguriert ist.

17. Verwendung einer hybriden multispektralen Detektionsvorrichtung (10) nach einem der Ansprüche 1 bis 11, wobei die elektromagnetische Strahlung auf der Seite des Siliciumsubstrats (31) empfangen wird, auf die der zweite Detektor (22) aufgeklebt ist.

18. Verwendung einer hybriden multispektralen Detektionsvorrichtung (10) nach einem der Ansprüche 1 bis 11, wobei die elektromagnetische Strahlung auf der Seite des Siliciumsubstrats (31) empfangen wird, die der Seite gegenüberliegt, auf die der zweite Detektor (22) aufgeklebt ist.

19. Verwendung nach einem der Ansprüche 17 bis 18, wobei die hybride multispektrale Detektionsvorrichtung in ein multispektrales Detektionssystem nach einem der Ansprüche 12 bis 16 installiert ist.

## Claims

1. Hybrid multispectral detection device (10) based on monolithic elements, comprising:
- a silicon substrate (31),
- a first detector (21) which is installed in the silicon substrate (31), the first detector (21) comprising a plurality of first juxtaposed sensors (101), the first sensors (101) being configured to provide an electrical signal which is dependent on the electromagnetic radiation received in the visible range and near infrared range, and the first sensors (101) being arranged in order to form a first group of at least one line (210) of first sensors,
- a second detector (22) which is installed in an absorbent substrate (32) and which comprises at least one material taken from a material III-V and a material II-VI, the second detector (22) comprising a plurality of second juxtaposed sensors (201), the second sensors (201) being configured to provide an electrical signal dependent on the electromagnetic radiation received in the infrared range, the second sensors being arranged in order to form a second group of at least one line (220) of second sensors, the lines (210, 220) of the first and second groups of at least one line being mutually parallel, the second detector (22) being adhesively bonded to the silicon substrate (31), each sensor (201) of the second detector (22) comprising at least one connection (35) which is configured to transmit the signals of the sensor (201) to a reading circuit (310) which is common to both detectors (21, 22), the reading circuit being installed in the silicon substrate (31) and being configured to integrate simultaneously and synchronously the signals from the various sensors (101, 201) and to provide, at the output, at least one video signal which is representative of the electromagnetic radiation received by all of the sensors,
the hybrid detection device (10) being **characterised in that**:
- the absorbent substrate (32) covers only a zone of the silicon substrate (31) without any first sensors (101),
- and **in that** the hybrid device comprises a first interference filter (25) which covers the first detector (21) and a second interference filter (26) which covers the second detector (22), the filters (25, 26) each being configured to filter the electromagnetic radiation received by the sensors (101, 201) of the detectors (21, 22) and each filter (25, 26) having a different spectral transmission range.

2. Device according to any one of the preceding claims, wherein the second sensors are arranged in order to form a second group of several lines of second sensors in a plane perpendicular to a stacking direction of the silicon substrate (31) and the absorbent substrate (32).

3. Device according to the preceding claim, wherein the second sensors are remote from the edge of the absorbent substrate (32) in the plane.

4. Device according to the preceding claim, wherein the distance between each second sensor (201) and the edge of the absorbent substrate (32) in the plane is greater than the diffusion length of the carriers in the absorbent substrate (32).

5. Device according to any one of the preceding claims, wherein the first sensors and the second sensors are separated by a distance between 10 micrometres and 20 micrometres in a stacking direction (z) of the silicon substrate (31) and the absorbent substrate (32).

6. Device (10) according to any one of the preceding claims, wherein the absorbent substrate is made from indium gallium arsenide.

7. Device according to any one of the preceding claims, wherein the second sensors (201) are configured to provide an electrical signal which is proportional to the electromagnetic radiation received in the infrared range, and the first sensors (101) are configured to provide an electrical signal which is proportional to the electromagnetic radiation received in the visible and near infrared range.

8. Device (10) according to any one of the preceding claims, wherein the sensors (201) of the second detector (22) are configured to cover the spectral range of near infrared and the spectral range of short and medium wavelength infrared.

9. Device (10) according to any one of the preceding claims, wherein at least one of the detectors comprises a sensor matrix (101, 201).

10. Device (10) according to the preceding claim, wherein at least one of the detectors is a detector with time lag and integration.

11. Device (10) according to any one of the preceding claims, wherein the hybrid multispectral detection device (10) comprises a cooling device which is configured to lower the temperature of the second sensors (201).

12. Multispectral detection system which is intended to be fitted on-board an airborne platform, the system being **characterised in that** it comprises a hybrid multispectral detection device (10) according to any one of the preceding claims, at least one lens (11) which is configured to focus the electromagnetic radiation in a central plane between the planes in which the various sensors (101, 201) of the detection device (10) are installed, a control and video processing module (41), a signal compression and storage module (42).

13. System according to the preceding claim, wherein the system comprises a transmission device (43).

14. System according to any one of claims 12 to 13, wherein the system comprises a scanning device which is configured to move the detection device (10).

15. System according to any one of claims 12 to 13, wherein the system comprises at least one movable reflection device which is configured to scan the sub-swathes to be observed.

16. System according to any one of claims 12 to 13, wherein the system is configured to scan a zone which is intended to be observed in accordance with a "pushbroom" imaging mode.

17. Use of a hybrid multispectral detection device (10) according to any one of claims 1 to 11, wherein the electromagnetic radiation is received on the face of the silicon substrate (31) to which the second detector (22) is adhesively bonded.

18. Use of a hybrid multispectral detection device (10) according to any one of claims 1 to 11, wherein the electromagnetic radiation is received on the face of the silicon substrate (31) opposite the face to which the second detector (22) is adhesively bonded.

19. Use according to any one of claims 17 to 18, wherein the hybrid multispectral detection device is installed in a multispectral detection system according to any one of claims 12 to 16.
